(19) Europäisches Patentamt
European Patent Office
Office européen des brevets

(11) **EP 3 474 394 A1**

(12) **EUROPEAN PATENT APPLICATION**

(43) Date of publication:
**24.04.2019 Bulletin 2019/17**

(51) Int Cl.:
***H01S 5/183*** *(2006.01)*

(21) Application number: **17196740.9**

(22) Date of filing: **17.10.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Koninklijke Philips N.V.**
**5656 AE Eindhoven (NL)**

(72) Inventor: **GERLACH, Philipp Henning**
**5656 AE Eindhoven (NL)**

(74) Representative: **de Haan, Poul Erik et al**
**Philips International B.V.**
**Philips Intellectual Property & Standards**
**High Tech Campus 5**
**5656 AE Eindhoven (NL)**

(54) **VERTICAL CAVITY SURFACE EMITTING LASER**

(57)    A Vertical Cavity Surface Emitting Laser comprises a substrate (101), a mesa structure (103), a first distributed Bragg reflector (110), a second distributed Bragg reflector (120), an active layer structure (115) sandwiched between the first distributed Bragg reflector (110) and the second distributed Bragg reflector (120), a current aperture (125) arranged within the first distributed Bragg reflector (110) or the second distributed Bragg reflector (120), a first electrode (100) and a second electrode (135) arranged to provide an electrical current to the active layer structure (115), wherein the mesa structure (103) comprises in a cross-section (10) through a layer of the mesa structure (103) 2n+1 neckings (127) with 1≤n≤4, preferably 1≤n≤3 and more preferably 1≤n≤2, wherein the neckings define a modulation amplitude with respect to a circular reference mesa structure (150), wherein the circular reference mesa structure (150) has an area which is the same as an area of the mesa structure (103) in the cross-section (10).

**Fig. 2**

**EP 3 474 394 A1**

**Description**

FIELD OF THE INVENTION:

The invention relates to a Vertical Cavity Surface Emitting Laser and a method of manufacturing the Vertical Cavity Surface Emitting Laser. The invention further relates to a datacom device comprising the Vertical Cavity Surface Emitting Laser.

BACKGROUND OF THE INVENTION:

Vertical Cavity Surface Emitting Lasers (VCSELs) especially for next-generation datacom applications (e.g. high-speed VCSELs for more than 25 Gb per second) are bound by strict requirements. "Low spectral width" ("RMS") is one important requirement from the application. The requirement is RMS < 0.6 nm. This requirement is very complex to fulfill because the RMS value is an indirect parameter which is calculated by means of the optical emission spectrum of the VCSEL. Several approaches have been made in order to decrease the RMS value by means of design parameters of the VCSEL. Thinner oxide layers which are used to define the current aperture have shown lower RMS values. Such thin oxide layers do have the disadvantage that the capacity increases which contradicts the high-speed requirement. It has been further shown that localized etching on the VCSEL facet may help to meet the RMS specification. Complexity of local etching is high which may cause drawbacks with respect to reliability and yield. Therefore, a reliable and low cost approach is needed in order to fulfill the RMS requirement.

SUMMARY OF THE INVENTION:

It is thus an object of the present invention to provide a Vertical Cavity Surface Emitting Laser for datacom applications.

The object is achieved with the Vertical Cavity Surface Emitting Laser according to claim 1. Advantageous embodiments of the Vertical Cavity Surface Emitting Laser are subject matter of the dependent claims or are described in the subsequent portions of the description and preferred embodiments.

According to a first aspect a Vertical Cavity Surface Emitting Laser. The Vertical Cavity Surface Emitting Laser comprises a substrate, a mesa structure, a first distributed Bragg reflector, a second distributed Bragg reflector, an active layer structure sandwiched between the first distributed Bragg reflector and the second distributed Bragg reflector, a current aperture arranged within the first distributed Bragg reflector or the second distributed Bragg reflector, a first electrode and a second electrode arranged to provide an electrical current to the active layer structure. The term "mesa structure" comprises each isolated laser light emitting structure on the substrate. The light-emitting structure may be isolated by means of etching through the semiconductor layers to form isolated areas of the active layer. The mesas structure may therefore extend above at least a part of the substrate in accordance with the classical understanding of the term "mesa" in the VCSEL-technology describing a pillar or any other shape that is the result of an etching step. The mesa structure(s) are essentially non-etched remains of an etching step. The mesas structures may be densely packed such that the mesas or laser light emitting structures are separated by "narrow canyons". The mesa structure comprises in a cross-section through a layer of the mesa structure 2n+1 neckings with $1 \leq n \leq 4$, preferably $1 \leq n \leq 3$ and more preferably $1 \leq n \leq 2$, wherein the neckings define a modulation amplitude with respect to a circular reference mesa structure. The circular reference mesa structure has an area which is the same as an area of the mesa structure in the cross-section. The 2n+1 neckings have the effect that the current or laser aperture of the VCSEL is not circular. This is essentially caused by the subsequent etching/oxidation of the current aperture. The etching/oxidation of the current aperture which is arranged in the dome or pillar of the mesa structure does have the effect that the non-etched area of the oxidized layer (current aperture) through which the current is confined does have a cross-section which is characterized by the same number of neckings like the mesa structure. The etching step essentially conserves the geometric characteristic of the mesa structure. The non-etched area of the oxidized layer (current aperture) seem to dominate the active area (area in which the current density is above threshold current) of the active layer when current is applied to the electrodes. The active area seems to be characterized by the same geometric characteristic (number of neckings) like the mesa structure and the current aperture.

Simulations have shown that such 2n+1 neckings of the active area reduce the root mean square spectral width (RMS value or width) of the VCSEL. The RMS value is calculated according to

$$\Delta\lambda_{RMS} = \sqrt{\sum_{i=1}^{n} \frac{P_i}{P_{tot}}(\lambda_i - \lambda_{mean})^2} \quad , \qquad \lambda_{mean} = \sum_{i=1}^{n} \frac{P_i}{P_{tot}}\lambda_i$$

where $P_i$ is the power in point i of the measured spectrum, $P_{tot}$ is the total power, $\lambda_i$ is the wavelength of point i and $\lambda_{mean}$ is the average wavelength. The RMS value of the Vertical Cavity Surface Emitting Laser is preferably smaller than 0.6 nm at a chip temperature of 25° C, more preferably smaller than 0.45 nm and most preferably smaller than 0.3 nm. The IEEE-803.2ae standard (10 Gbit/s over up to 300 m OM3 fiber), requires, for example, an RMS value < 0.45 nm. The simulations were confirmed by means of experiments in which VCSELs comprising five neckings (n = 2; pentagonal mesa structure) were compared with reference VCSELs with circular symmetric mesa structure. The optical spectra were compared for different currents. The VCSELs with pentagonal mesa structure have shown four optical modes in comparison to six optical modes of the VCSELs with circular mesa structure. The comparison was made for VCSELs with almost identical voltage characteristic but different mesa shape. The VCSEL is especially suited for datacom applications. Such datacom applications may, for example, be active optical cables and optical transceivers. The VCSEL and especially one or more array of such VCSELs may further be used in high brightness applications.

An average diameter of the mesa structure is preferably smaller than 35 $\mu$m, more preferably smaller than 25 $\mu$m. The average diameter of the mesas structure is determined based on a diameter of the circular reference mesa structure.

The modulation amplitude describes a maximum deviation of the outer circle appearance of the mesas structure with respect to the circular reference mesa structure. The modulation amplitude is preferably at least 0.5 $\mu$m, more preferably at least 0.75 $\mu$m and most preferably at least 1 $\mu$m. The modulation amplitude is preferably at least 10% of the diameter of the circular reference mesa structure.

The mesa structure may be characterized by a cloverleaf structure. Two adjacent neckings define in this case an outer section of the mesa structure (one clover leaf arranged between the two neckings. A width of the outer section between the two adjacent neckings is smaller than a maximum width of the outer section (the cloverleaf structure is getting broader after the two neckings). The 2n+1 neckings may define an inner section of the mesa structure. The inner section of the mesa structure maybe approximately circular. A diameter of the inner section may be smaller than the diameter of the circular reference mesa structure.

The Vertical Cavity Surface Emitting Laser may comprise at least a second current aperture, wherein a diameter of the second current aperture is different than a diameter of the current aperture. The second current aperture or further current aperture may be arranged below or above the first current aperture within the first or second distributed Bragg reflector.

The mesa structure may be arranged such that a number of optical modes at a defined driving current is reduced in comparison to a number of optical modes of a reference Vertical Cavity Surface Emitting Laser with the circular reference mesa structure at the defined driving current.

According to a second aspect a datacom device is provided. The datacom device comprises at least one Vertical Cavity Surface Emitting Laser as described above and a driver for driving the Vertical Cavity Surface Emitting Laser. The datacom device may be selected out of the group active optical cable and optical transceiver.

According to a third aspect a method of fabricating a Vertical Cavity Surface Emitting Laser for datacom applications is provided. The method comprises the steps of:

    providing a first electrode,
    providing a substrate,
    providing a first distributed Bragg reflector,
    providing an active layer,
    providing a second distributed Bragg reflector,
    providing a second electrode,
    providing a mesa structure comprising in a cross-section through a layer of the mesa structure 2n+1 neckings with 1≤n≤4, preferably 1≤n≤3 and more preferably 1≤n≤2,
    providing a current aperture arranged within the first distributed Bragg reflector or the second distributed Bragg reflector.

The steps need not necessarily be performed in the order given above. The current aperture is provided by etching or oxidizing a semiconductor layer which is arranged in the dome or pillar of the mesa structure.

It shall be understood that the VCSEL of claim 1-9 and the method of 12 have similar and/or identical embodiments, in particular, as defined in the dependent claims.

It shall be understood that a preferred embodiment of the invention can also be any combination of the dependent claims with the respective independent claim.

Further advantageous embodiments are defined below.

BRIEF DESCRIPTION OF THE DRAWINGS:

These and other aspects of the invention will be apparent from and elucidated with reference to the embodiments described hereinafter.

The invention will now be described, by way of example, based on embodiments with reference to the accompanying drawings.

In the drawings:

Fig. 1 shows a first embodiment of a Vertical Cavity Surface Emitting Laser (VCSEL)

Fig. 2 shows different examples of cross-sections in a plane of the semiconductor layers of the mesas structure with three neckings

Fig. 3 shows the simulated effect of a size of the modulation amplitude in case of the three neckings with respect to the RMS value

Fig. 4 shows examples of cross-sections in a plane of the semiconductor layers of the mesa structure with five neckings

Fig. 5 shows the simulated effect of a size of the modulation amplitude in case of the five neckings with respect to the RMS value

Fig. 6 shows a picture of a fully processed VCSEL with a pentagonal mesa structure

Fig. 7 shows a statistical evaluation of the RMS value of processed VCSELs with pentagonal mesa structure

Fig. 8 shows a statistical evaluation of the forward voltage of processed VCSELs with pentagonal mesa structure

Fig. 9 shows an evaluation of the effect of the size of the modulation amplitude of the process VCSELs with pentagonal mesa structure

In the Figures, like numbers refer to like objects throughout. Objects in the Figures are not necessarily drawn to scale.

DETAILED DESCRIPTION OF EMBODIMENTS:

Various embodiments of the invention will now be described by means of the Figures.

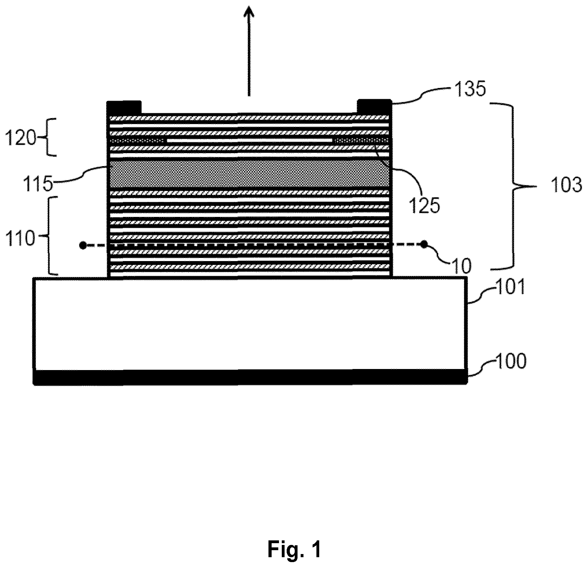

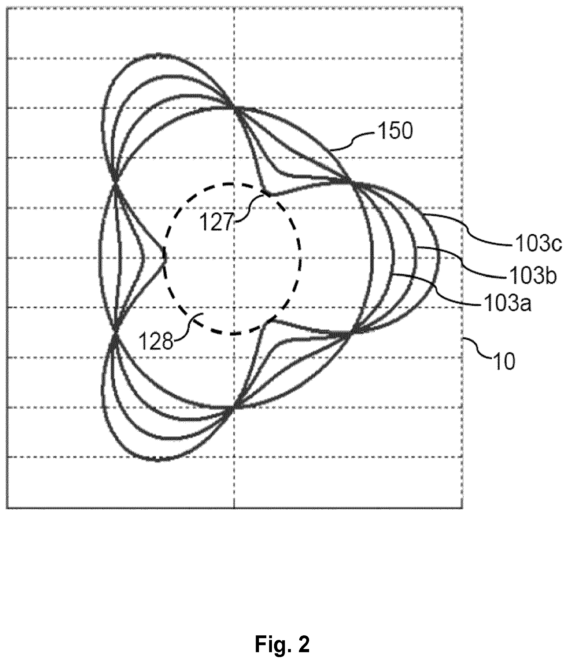

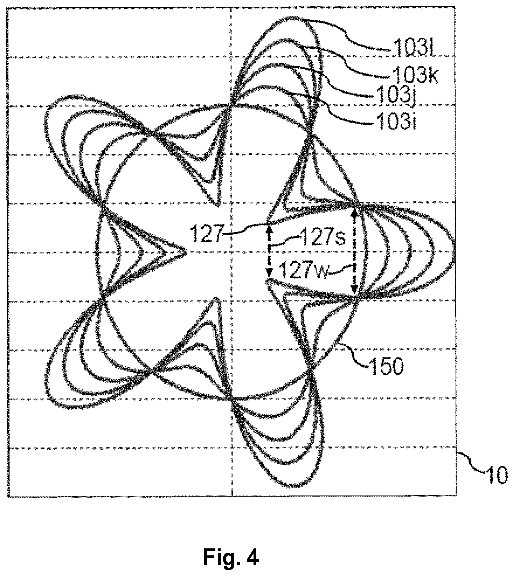

Fig. 1 shows a principal sketch of a cross section of a VCSEL perpendicular to the semiconductor layers of the VCSEL. The VCSEL is a top emitting VCSEL emitting laser light in a direction away from a substrate 101. On the bottom side of the substrate 101 a first electrode 100 is provided. On the top side of the substrate is a first DBR 110 provided comprising 30 pairs of layers with a first and a second refractive index. The pairs of layers of the first DBR 110 comprise AlGaAs/GaAs layers. The thickness of the layers is adapted to the emission wavelength of the VCSEL in order to provide the requested reflectivity of more than 99.9%. On top of the first DBR 110 is an active layer 115 provided. The active layer 115 comprises a quantum well structure for light generation. A n-current injection layer (not shown) may be arranged between the first DBR 110 and the active layer 115. A second DBR 120 is provided on top of the active layer. The second DBR 120 comprises 15 pairs of layers with a third and a fourth refractive index. The pairs of layers of the second DBR 120 comprise AlGaAs/GaAs layers. The first refractive index is thus the same as the third refractive index and the second refractive index is the same as the fourth refractive index. The thickness of the layers is adapted to the emission wavelength of the VCSEL in order to provide the requested reflectivity of around 95 % such that the laser light can be emitted through the second DBR 120. A p-charge carrier injection layer (not shown) maybe arranged between the active layer 115 and the second DBR 120. A current aperture 125 is arranged within the layer stack of the second DBR 120. A second electrode 135 surrounding the light emitting area is electrically arranged on top of the second DBR 120. The VCSEL emits laser light in the direction of the arrow via the second DBR 120 if an electrical current is applied by means of the first electrode 100 and the second electrode 135, wherein the current is confined by means of current aperture 125. The line indicated with reference sign 10 indicates a cross-section in a plane of the semiconductor layer structure of the VCSEL. Examples of such cross-sections are schematically shown in Fig. 2 and Fig. 4.

The results of the experiments and simulations also apply to VCSELs emitting laser light via the semiconductor substrate 101 (bottom emitters). The second DBR 120 would in this case be highly reflective and the first DBR 110 would be less reflective in order to enable laser emission through the semiconductor substrate 101. The first electrode 100 would in this case be arranged such that laser mission via the substrate is possible. The second electrode 135 would in this case preferably cover the whole second DBR 120.

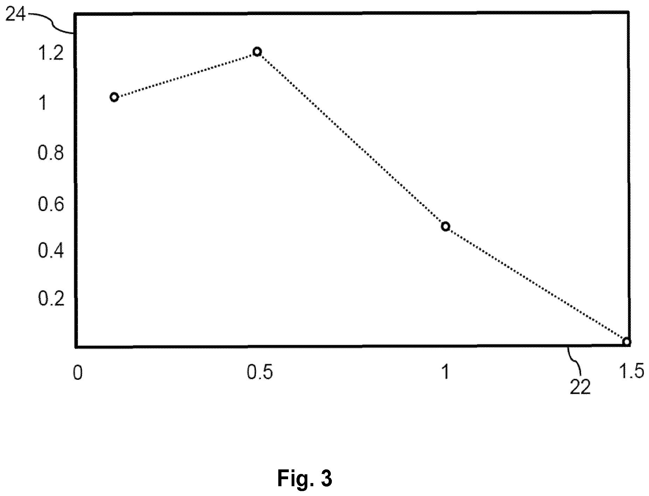

Fig. 2 shows different examples of cross-sections in a plane of the semiconductor layers 10 of the mesas structure 103 with three neckings 127 with different modulation amplitudes 22 (see also Fig. 3). Line 150 shows a cross-section of a circular reference mesa. The modulation amplitude 22 is defined by the maximum deviation of the cross section of the respective mesa in comparison to the circular reference mesa 150 with the same area in the cross section. A mesa structure 103 with three neckings 127 and 0.5 $\mu$m modulation amplitude 22 is shown by line 103 a. A mesa structure 103with three neckings 127 and 1 $\mu$m modulation amplitude 22 is shown by line 103b. A mesa structure 103with three neckings 127 and 1.5 $\mu$m modulation amplitude 22 is shown by line 103c. The inner section 128 of the mesa with the cross-section 103c is indicated by circle 128 touching the neckings 127 of cross-section 103c.

Fig. 3 shows the simulated effect of a size of the modulation amplitude 22 as sketched in Fig. 2 in case of the three neckings with respect to the RMS value 24. The simulations presuppose that the current aperture 125 is characterized by the same geometrical characteristic as the cross-section of the mesa structure discussed with respect to Fig. 2. That means that the number of neckings and the modulation amplitude of the mesa structure 103 and a non-oxidized area of the current aperture 125 is the same but smaller depending on the lateral oxidation/etching depth during the oxidation/etching process. Experiments have confirmed that this condition is met at least for standard oxidation width or depth of around 10 $\mu$m. Furthermore, it is assumed that the shape of the active area of the active layer 115 is determined by the geometry of the current aperture 125. The shape of the active area is therefore the same as the shape of the mesa structure 103 but with reduced diameter taking a reference diameter of a circular reference active area with the same area as the active area caused by the different mesa structures 103a, 103b, 103c.The RMS value 24 decreases if the modulation amplitude 22 is bigger than 0.5 $\mu$m. The simulated RMS value 24 is lower than 0.6 in case of a modulation amplitude 22 of 1 $\mu$m. The simulated RMS value 24 is even lower than 0.1 in case of a modulation amplitude of 1.5 $\mu$m.

Fig. 4 shows examples of cross-sections in a plane of the semiconductor layers 10 of the mesa structure 103 with five neckings 127. Line 150 shows a cross-section of a circular reference mesa. A mesa structure 103 with five neckings 127 and 0.5 $\mu$m modulation amplitude 22 is shown by line 103i. A mesa structure 103 with five neckings 127 and 1 $\mu$m modulation amplitude 22 is shown by line 103j. A mesa structure 103 with five neckings 127 and 1.5 $\mu$m modulation amplitude 22 is shown by line 103k. A mesa structure 103 with five neckings 127 and 2 $\mu$m modulation amplitude 22 is shown by line 1031. The mesas with 1.5 $\mu$m and 2micrometer modulation amplitude are characterized by a width of the mesa structure 103 between two neckings 127s which is smaller than a maximum width of an outer section of the mesa 127w. The outer sections of the mesa structure 103 are defined by two adjacent neckings 127. The outer sections of the mesa are everything which is arranged out of the inner section of the mesa 128 (see Fig. 2).

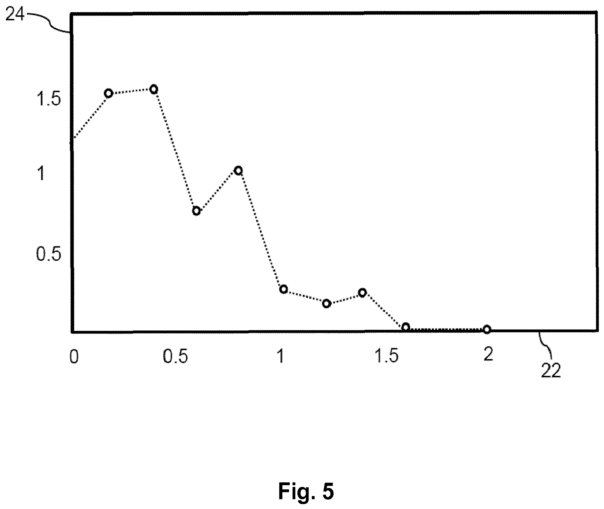

Fig. 5 shows the simulated effect of a size of the modulation amplitude 22 in case of the five neckings 127 with respect to the RMS value 24. The preconditions of these simulations are the same as discussed with respect to Fig. 3. The simulated RMS value 24 is lower than 0.75 nm in case of a modulation amplitude 22 of 0.5 $\mu$m. The simulated RMS value 24 is lower than 0.3 in case of a modulation amplitude of 1 $\mu$m. The simulated RMS value 24 is lower than 0.3 in case of a modulation amplitude 22 of 1.5 $\mu$m. The simulated RMS value 24 is lower than 0.1 in case of a modulation amplitude of 2 $\mu$m.

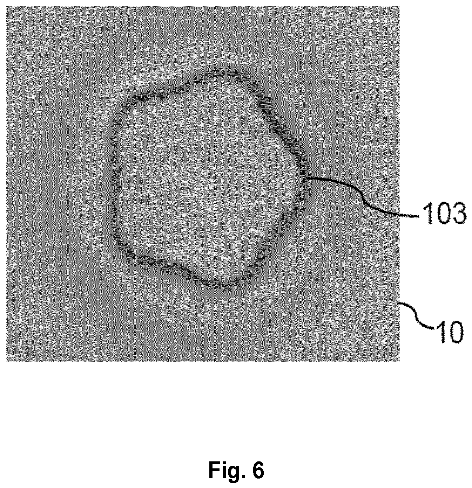

Fig. 6 shows a top view of a fully processed VCSEL with a pentagonal mesa structure 103.

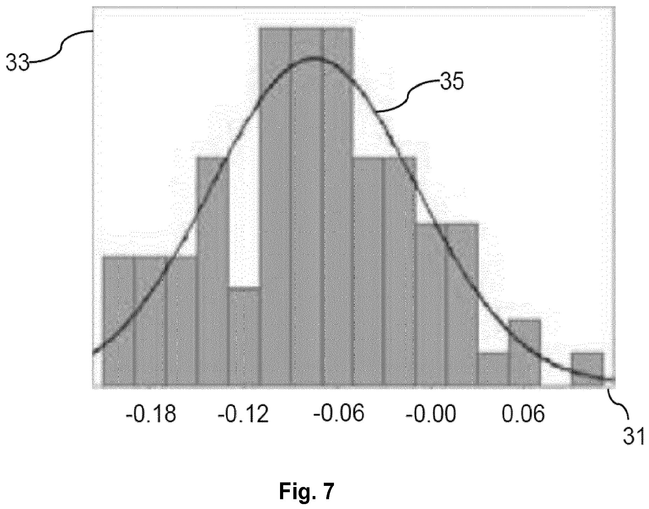

Fig. 7 shows a statistical evaluation of the RMS value of processed VCSELs with pentagonal mesa structure 103. The ordinate shows a number of investigated VCSELs 33 and the abscissa the difference in RMS value 31. The modulation amplitude 22 of the investigated VCSELs is between 0.9 $\mu$m and 1.1 $\mu$m. The results are compared with circular reference mesas with the same size and the same threshold current. The average deviation from the RMS value of the circular reference mesas is -0.075 nm with a confidence interval which is less than 0 nm. The pentagonal design leads to a statistically significant reduction in RMS value. The experimental results therefore support the simulated results.

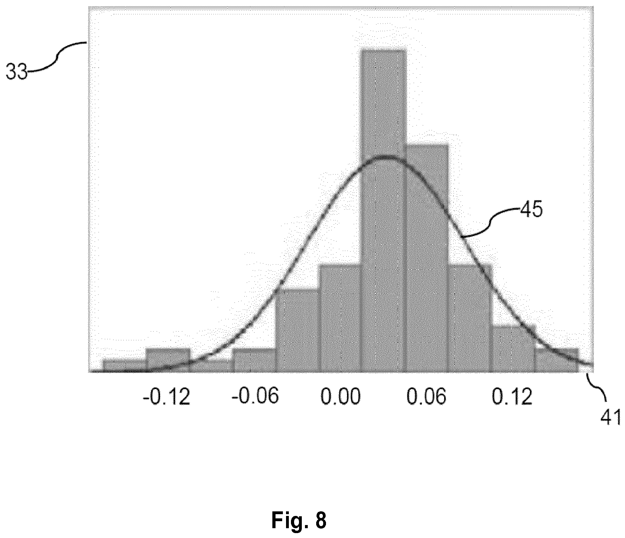

Fig. 8 shows a statistical evaluation of the difference in forward voltage 41 of processed VCSELs with pentagonal mesa structure 103. The experimental results show that the pentagonal design increases the forward voltage 41 around 31 mV.

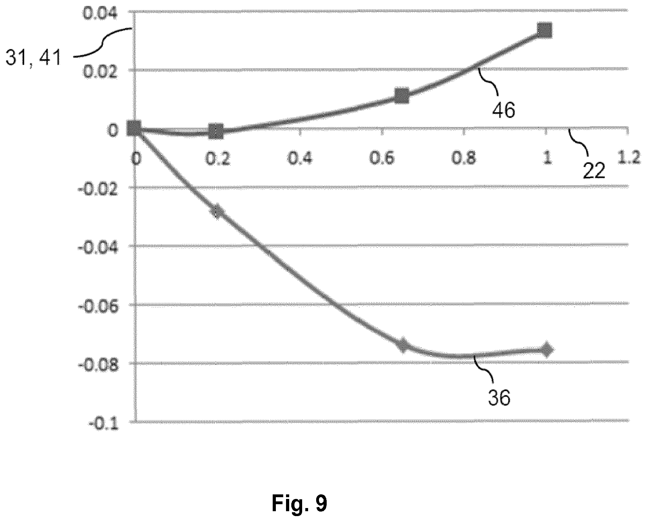

Fig. 9 shows the measured effect of a size of the modulation amplitude 22 in case of the five neckings 127 (pentagonal design) with respect to the RMS value 24. A modulation amplitude 22 of 0 $\mu$m is equal to the circular mesa, so there is no difference in RMS value to be expected. The higher the modulation amplitude 22, the stronger is the impact on RMS value. The deviation between the simulated results (see Fig. 5) and experimental results is most likely caused by the manufacturing process which has to be optimized. Furthermore, the preconditions of the simulation that the resulting active area of the active layer 115 when applying an electrical current is with respect to its geometrical characteristics exactly the same as the geometrical characteristics of the mesa structure 103 may not be perfectly fulfilled. Such deviations may be addressed by slight adaptions of the design of the mesa structure 103 and the corresponding etching process.

While the invention has been illustrated and described in detail in the drawings and the foregoing description, such illustration and description are to be considered illustrative or exemplary and not restrictive.

From reading the present disclosure, other modifications will be apparent to persons skilled in the art. Such modifications may involve other features which are already known in the art and which may be used instead of or in addition to features already described herein.

Variations to the disclosed embodiments can be understood and effected by those skilled in the art, from a study of the drawings, the disclosure and the appended claims. In the claims, the word "comprising" does not exclude other elements or steps, and the indefinite article "a" or "an" does not exclude a plurality of elements or steps. The mere fact that certain measures are recited in mutually different dependent claims does not indicate that a combination of these measures cannot be used to advantage.

Any reference signs in the claims should not be construed as limiting the scope thereof.

LIST OF REFERENCE NUMERALS:

| | |
|---|---|
| 10 | plane parallel and across the layer structure of the VCSEL |
| 22 | modulation amplitude |
| 24 | RMS value |
| 31 | difference in RMS value |
| 33 | number of investigated VCSELs |
| 35 | normal distribution of difference in RMS value |
| 36 | median of difference in RMS value |
| 41 | difference in forward voltage |
| 45 | normal distribution of difference in forward voltage |
| 46 | median of difference in forward voltage |
| 100 | first electrode |
| 101 | substrate |
| 103 | mesa structure |
| 110 | first distributed Bragg reflector |
| 115 | active layer |
| 120 | second distributed Bragg reflector |
| 125 | current aperture |
| 103a | mesa structure with three neckings and 0.5 $\mu$m modulation amplitude |
| 103b | mesa structure with three neckings and 1 $\mu$m modulation amplitude |
| 103c | mesa structure with three neckings and 1.5 $\mu$m modulation amplitude |
| 103i | mesa structure with five neckings and 0.5 $\mu$m modulation amplitude |
| 103j | mesa structure with five neckings and 1 $\mu$m modulation amplitude |
| 103k | mesa structure with five neckings and 1.5 $\mu$m modulation amplitude |
| 1031 | mesa structure with five neckings and 2 $\mu$m modulation amplitude |
| 127 | necking |
| 127s | width of the mesa structure between two neckings |
| 127w | maximum width of outer section of mesa structure |
| 128 | inner section of mesa structure |
| 135 | second electrode |
| 150 | circular reference mesa structure |

**Claims**

1. A Vertical Cavity Surface Emitting Laser, wherein the Vertical Cavity Surface Emitting Laser comprises a substrate (101), a mesa structure (103), a first distributed Bragg reflector (110), a second distributed Bragg reflector (120), an active layer structure (115) sandwiched between the first distributed Bragg reflector (110) and the second distributed Bragg reflector (120), a current aperture (125) arranged within the first distributed Bragg reflector (110) or the second distributed Bragg reflector (120), a first electrode (100) and a second electrode (135) arranged to provide an electrical current to the active layer structure (115), wherein the mesa structure (103) comprises in a cross-section (10) through a layer of the mesa structure (103) 2n+1 neckings (127) with $1 \leq n \leq 4$, preferably $1 \leq n \leq 3$ and more preferably $1 \leq n \leq 2$, wherein the neckings define a modulation amplitude with respect to a circular reference mesa structure (150), wherein the circular reference mesa structure (150) has an area which is the same as an area of the mesa structure (103) in the cross-section (10).

2. The Vertical Cavity Surface Emitting Laser according to claim 1, wherein a RMS value of the Vertical Cavity Surface Emitting Laser is smaller than 0.6 nm.

3. The Vertical Cavity Surface Emitting Laser according to claim 1 or 2, wherein an average diameter of the mesa structure (103) is smaller than 35 $\mu$m.

4. The Vertical Cavity Surface Emitting Laser according to anyone of the preceding claims, wherein the modulation amplitude is at least 0.5 $\mu$m, more preferably at least 0.75 $\mu$m and most preferably at least 1 $\mu$m.

5. The Vertical Cavity Surface Emitting Laser according to anyone of the preceding claims, wherein the modulation amplitude is at least 10% of a diameter of the circular reference mesa structure (150).

6. The Vertical Cavity Surface Emitting Laser according to anyone of the preceding claims, wherein two adjacent neckings (127) define an outer section of the mesa structure (103), wherein a width of the outer section (127s) between the two adjacent neckings (127) is smaller than a maximum width of the outer section (127w).

7. The Vertical Cavity Surface Emitting Laser according to anyone of the preceding claims, wherein the 2n+1 neckings (127) define an inner section (128) of the mesa structure (103), wherein a diameter of the inner section (128) is smaller than the diameter of the circular reference mesa structure (150).

8. The Vertical Cavity Surface Emitting Laser according to anyone of the preceding claims, wherein the Vertical Cavity Surface Emitting Laser comprises at least a second current aperture, wherein a diameter of the second current aperture is different than a diameter of the current aperture (125).

9. A datacom device comprising at least one Vertical Cavity Surface Emitting Laser according to anyone of claims 1 to 8.

10. The datacom device according to claim 9, wherein the datacom device is selected out of the group active optical cable and optical transceiver.

11. A method of fabricating a Vertical Cavity Surface Emitting Laser, the method comprising the steps of:

   providing a first electrode (100),
   providing a substrate (101),
   providing a first distributed Bragg reflector (110),
   providing an active layer (115),
   providing a second distributed Bragg reflector (120),
   providing a second electrode (135),
   providing a mesa structure (103) comprising in a cross-section (10) through a layer of the mesa structure (103) 2n+1 neckings (127) with 1≤n≤4, preferably 1≤n≤3 and more preferably1≤n≤2
   providing a current aperture (125) arranged within the first distributed Bragg reflector (110) or the second distributed Bragg reflector (120).

**Fig. 1**

**Fig. 2**

**Fig. 3**

**Fig. 4**

**Fig. 5**

—103

—10

**Fig. 6**

**Fig. 7**

**Fig. 8**

**Fig. 9**

Europäisches
Patentamt

European
Patent Office

Office européen
des brevets

# EUROPEAN SEARCH REPORT

Application Number

EP 17 19 6740

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/054290 A1 (HATAKEYAMA HIROSHI [JP]) 4 March 2010 (2010-03-04)<br>* paragraphs [0073] - [0088]; figures 1a,1b *<br>* paragraph [0002] * | 1-11 | INV.<br>H01S5/183 |
| X | US 2017/201066 A1 (CHEN HAOSHUO [US] ET AL) 13 July 2017 (2017-07-13)<br>* paragraphs [0035] - [0041]; figures 2A,2B *<br>* paragraphs [0021] - [0031]; figure 1B * | 1-11 | |
| X | US 2012/281293 A1 (GRONENBORN STEPHAN [DE] ET AL) 8 November 2012 (2012-11-08)<br>* paragraph [0051]; figure 1 * | 1,3-7,11 | |
| X | CHEN C C ET AL: "Various high-order modes in vertical-cavity surface-emitting lasers with equilateral triangular lateral confinement",<br>OPTICS LETTERS, OPTICAL SOCIETY OF AMERICA,<br>vol. 33, no. 5, 1 March 2008 (2008-03-01), pages 509-511, XP001511922,<br>ISSN: 0146-9592, DOI: 10.1364/OL.33.000509<br>* page 509, right-hand column, paragraph 2 - page 510, left-hand column, paragraph 1; figure 1 * | 1,3-5,7,11 | |

TECHNICAL FIELDS
SEARCHED (IPC)

H01S

The present search report has been drawn up for all claims

| Place of search | Date of completion of the search | Examiner |
|---|---|---|
| Munich | 26 March 2018 | Riechel, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 19 6740

This annex lists the patent family members relating to the patent documents cited in the above-mentioned European search report.
The members are as contained in the European Patent Office EDP file on
The European Patent Office is in no way liable for these particulars which are merely given for the purpose of information.

26-03-2018

| Patent document cited in search report | | | Publication date | Patent family member(s) | | | Publication date |
|---|---|---|---|---|---|---|---|
| US 2010054290 | A1 | | 04-03-2010 | JP | WO2007116659 | A1 | 20-08-2009 |
| | | | | US | 2010054290 | A1 | 04-03-2010 |
| | | | | WO | 2007116659 | A1 | 18-10-2007 |
| US 2017201066 | A1 | | 13-07-2017 | US | 2017201066 | A1 | 13-07-2017 |
| | | | | WO | 2017123493 | A1 | 20-07-2017 |
| US 2012281293 | A1 | | 08-11-2012 | CN | 102742100 | A | 17-10-2012 |
| | | | | EP | 2478602 | A2 | 25-07-2012 |
| | | | | JP | 5894529 | B2 | 30-03-2016 |
| | | | | JP | 2013502717 | A | 24-01-2013 |
| | | | | KR | 20120053045 | A | 24-05-2012 |
| | | | | US | 2012281293 | A1 | 08-11-2012 |
| | | | | WO | 2011021140 | A2 | 24-02-2011 |